Europäisches Patentamt

(19) European Patent Office

Office européen des brevets

(11) **EP 0 890 983 A1**

## (12) EUROPEAN PATENT APPLICATION

(43) Date of publication:
**13.01.1999 Bulletin 1999/02**

(51) Int. Cl.$^6$: **H01L 21/66**, G03F 7/20

(21) Application number: **97310515.8**

(22) Date of filing: **23.12.1997**

(84) Designated Contracting States:
**AT BE CH DE DK ES FI FR GB GR IE IT LI LU MC NL PT SE**
Designated Extension States:
**AL LT LV MK RO SI**

(30) Priority: **11.07.1997 JP 186954/97**

(71) Applicant:
**Oki Electric Industry Co., Ltd.**
**Tokyo (JP)**

(72) Inventors:
• **Yamamoto, Yasuhiro**
**7-12, Toranomon 1-chome, Minato-ku Tokyo (JP)**
• **Watanabe, Akira**
**7-12, Toranomon 1-chome, Minato-ku Tokyo (JP)**

(74) Representative:
**Read, Matthew Charles et al**
**Venner Shipley & Co.**
**20 Little Britain**
**London EC1A 7DH (GB)**

(54) **Measurement pattern set and method for measuring dimension accuracy and overlay accuracy of circuit pattern**

(57)     A measurement pattern set includes a first pattern formed on a lower layer, which is to be the basis of the measurement; and a second pattern formed on an upper layer that is the same level of the circuit pattern. The second pattern is arranged to adjoin to the first pattern. The first and second patterns are measured in size so as to calculate a dimension error of the second pattern relative to its design value and an overlay error of the second pattern relative to the first pattern at the same time. The dimension accuracy and overlay accuracy of the circuit pattern is calculated in response to the above calculated dimension error and the overlay error.

*FIG. 1*

EP 0 890 983 A1

**Description**

CROSS REFERENCE TO RELATED APPLICATION

This application claims the priority of Application No. H09-186954, filed July 11, 1997 in Japan, the subject matter of which is incorporated herein by reference.

TECHNICAL FIELD OF THE INVENTION

The present invention relates to a photolithography process in semiconductor apparatus fabrication. And more particularly, to a measurement pattern set and a method for measuring dimension accuracy and overlay accuracy of a circuit pattern, which is transferred onto a substrate surface. BACKGROUND OF THE INVENTION

In fabrication of a semiconductor integrated circuit, photolithography processes are important to improve quality of the semiconductor integrated circuit. Such photolithography processes are performed using a projection aligner.

Conventionally, a circuit pattern formed on a reticle is repeatedly transferred onto a semiconductor substrate, such as wafer, using the projection aligner. The transferred circuit pattern on the wafer is measured in size relative to design requirement, and overlay accuracy relative to a pattern in the under layer is measured as well.

In a conventional method, the circuit pattern is provided with a measurement pattern, which is specialized for pattern measurement. Such a measurement pattern is detected by a specialized measurement device, and the measured size is compared to its design value to provide a dimension error of the circuit pattern. In response to the dimension error, the circuit pattern is decided whether to be in a predetermined allowable range of dimension accuracy standard. When the dimension error is within the dimension accuracy standard, the circuit pattern is acceptable. On the other hand, the dimension error of the circuit pattern is out of the standard, the chip including the unacceptable circuit pattern is rejected as a defective product.

For detecting the position of the circuit pattern relative to the pattern on the lower layer, another specialized measurement pattern is used. On the lower layer, another specialized measurement pattern is formed as well. Those two measurement patterns on the top and lower layer are detected by an overlay measurement device. The difference in position between the two specialized measurement patterns on the top and lower layers is compared to an overlay accuracy standard.

As mentioned above, when the circuit pattern transferred on the wafer is decided to be acceptable according both to the dimension accuracy standard and overlay accuracy standard, the wafer shifts to the next process.

The above mentioned conventional method, however, has the following problems:

(1) For measuring the dimension accuracy and overlay accuracy of the circuit pattern, two different specialized devices are required.
(2) For measuring the dimension accuracy and overlay accuracy of the circuit pattern, it is required that two different specialized measurement patterns are formed on the substrate.
(3) The dimension accuracy and overlay accuracy is decided using different devices, so that it takes long time for performing the measurement process.
(4) Because the dimension accuracy and overlay accuracy is decided in accordance with the different standards, it is required to perform another calculation in order to decide the total accuracy (pattern quality) of the circuit pattern. Generally, in the process of the total accuracy measurement, the allowable range of overlay accuracy may be widened if the circuit pattern is within the range of the dimension accuracy standard.

OBJECTS OF THE INVENTION

Accordingly, an object of the invention is to provide a measurement pattern set, with which dimension accuracy and overlay accuracy of a circuit pattern can be decided easily in a short time.

Another object of the invention is to provide a method for measuring dimension accuracy and overlay accuracy of a circuit pattern, by which the dimension accuracy and overlay accuracy of the circuit pattern can be decided easily in a short time.

Still another object of the invention is to provide an apparatus for measuring dimension accuracy and overlay accuracy of a circuit pattern, by which the dimension accuracy and overlay accuracy of the circuit pattern can be decided easily with simple structure.

Additional objects, advantages and novel features of the invention will be set forth in part in the description that follows, and in part will become apparent to those skilled in the art upon examination of the following or may be learned by practice of the invention. The objects and advantages of the invention may be realized and attained by means of the instrumentalities and combinations particularly pointed out in the appended claims.

## SUMMARY OF THE INVENTION

A measurement pattern set according to a first aspect of the invention includes a first pattern formed on a lower layer, which is to be the basis of the measurement; and a second pattern formed on an upper layer that is the same level of the circuit pattern. The second pattern is arranged to adjoin to the first pattern. The first and second patterns are measured in size so as to calculate a dimension error of the second pattern relative to its design value and an overlay error of the second pattern relative to the first pattern at the same time. The dimension accuracy and overlay accuracy of the circuit pattern is calculated in response to the above calculated dimension error and the overlay error.

In a method according to a second aspect of the invention, a first pattern is formed on a lower layer, which is to be the basis of the measurement. Then, a second pattern is formed on an upper layer that is the same level of the circuit pattern, in which the second pattern is arranged to adjoin to the first pattern. Next, sizes of the first and second patterns are measured so as to calculate a dimension error of the second pattern relative to its design value and an overlay error of the second pattern relative to the first pattern at the same time. And then, the dimension accuracy and overlay accuracy of the circuit pattern is calculated in response to the above calculated dimension error and the overlay error.

An apparatus according to a third aspect of the invention includes a measurement device that measures sizes of first and second patterns at the same time. The first pattern is formed on a lower layer and the second pattern is formed on an upper layer that is the same level of the circuit pattern. The apparatus further includes a calculation unit that calculates a dimension error of the second pattern relative to its design value and an overlay error of the second pattern relative to the first pattern at the same time, and sums up the dimension error and the overlay error. The apparatus is also provided with a decision unit that compares the sum of the dimension error and overlay error of the second pattern to a predetermined reference value to decide whether the total pattern quality of the circuit pattern is in a standard range or not.

According to the invention, the dimension accuracy and overlay accuracy of the circuit pattern can be decided with a single measurement device.

In the invention, each of the first and second patterns may be designed so that sizes both in X and Y directions are measured at the same time. The patterns can be measured in size both in X and Y directions at the same time, and the pattern quality of the circuit pattern can be decided for each direction independently.

Further, the first pattern may include a pair of line patterns which extend in the X and Y directions on the difference layers, respectively. In this case, the pattern quality of the circuit pattern can be decided relative to the different layers for each direction independently.

In addition, the first pattern may include a pair of line patterns which are arranged at both sides of a line extending in the X direction on two different layers, respectively; and another pair of line patterns which are arranged at both sides of a line extending in the Y direction on another two different layers, respectively, so that the overlay accuracy is measured relative to each of those four different layers. In this case, the pattern quality of the circuit pattern can be decided relative to two different processes (layers) in X direction, and it can be decided relative to another two different processes (layers) in Y direction, as well. Namely, the pattern quality can be decided relative to four different processes (layers).

## BRIEF DESCRIPTION OF THE DRAWINGS

Fig. 1 is an explanatory view showing an apparatus for measuring dimension accuracy and overlay accuracy of a circuit pattern transferred onto a wafer, according to the invention.

Fig. 2 is a plan view showing a measurement pattern set of a first preferred embodiment of the invention.

Fig. 3 is a flow chart showing the operation for deciding a pattern quality of a circuit pattern, using the measurement pattern set shown in Fig. 2.

Fig. 4 is a plan view showing a measurement pattern set of a second preferred embodiment of the invention.

Fig. 5 is a plan view showing a measurement pattern set of a third preferred embodiment of the invention.

Fig. 6 is a plan view showing a measurement pattern set of a fourth preferred embodiment of the invention.

## DETAILED DISCLOSURE OF THE INVENTION

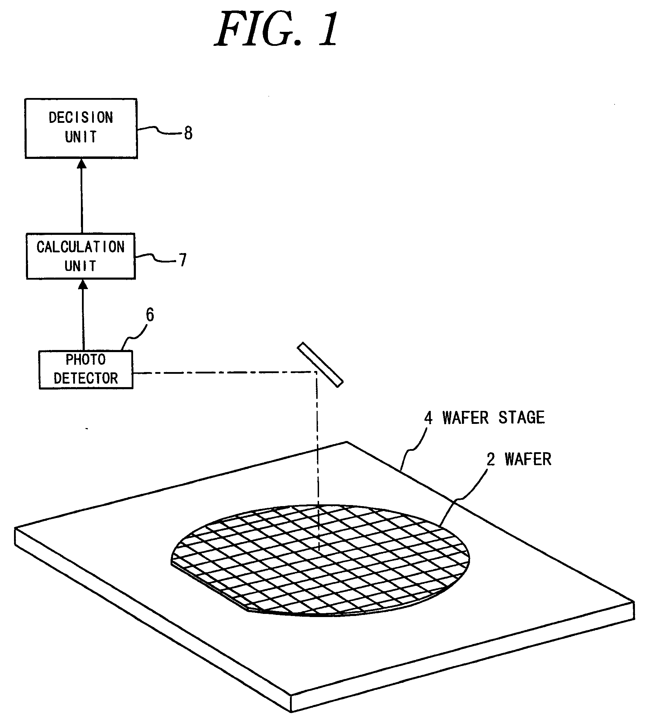

Fig. 1 an apparatus for measuring dimension accuracy and overlay accuracy of a circuit pattern (not shown) transferred onto a wafer 2, which is placed on a wafer stage 4. The apparatus includes a photo-detector 6, a calculation unit 7 connected to the photo-detector 6, and a decision unit 8 connected to the calculation unit 7. The photo-detector 6 includes an image sensor in which charges are introduced when light from a chip region of the wafer 2 is focused on the surface thereof. Namely, the photo-detector 6 detects first and second measurement patterns (11 and 12) transferred on a chip region of the wafer 2 to measure sizes ("a," "b" and "c") of those patterns at the same time. In each chip region on the wafer 2, a plurality of circuit patterns are transferred one over another.

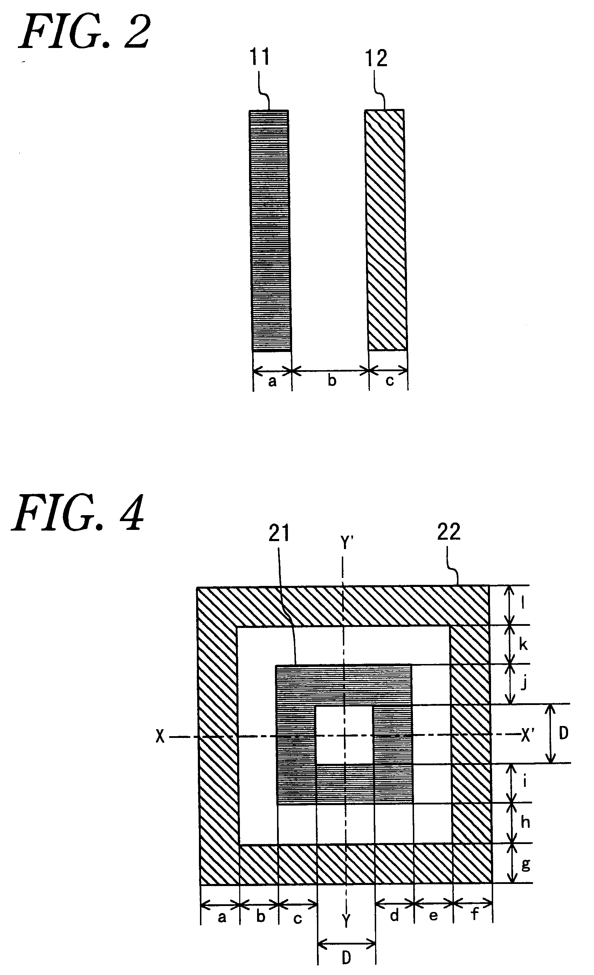

Fig. 2 shows a measurement pattern set, transferred onto the surface of the wafer 2, according to a first embodiment of the invention. The measurement pattern set includes the first line pattern 11 and the second line pattern 12, which may be transferred outside the circuit pattern in the chip region. The first line pattern 11 is an etching pattern formed on a lower layer (reference layer), which is to be the basis of overlay accuracy measurement. The second line pattern 12 is a resist pattern formed on an upper layer, overlapped on the lower layer. The first and second line patterns 11 and 12 are arranged at adjacent locations to each other.

Referring again to Fig. 1, the calculation unit 7 calculates a dimension error of the second measurement pattern 12 relative to its design value and an overlay error of the second measurement pattern 12 relative to the first measurement pattern 11 at the same time. The calculation unit 7 also sums up the dimension error and the overlay error. The decision unit 8 compares the sum of the dimension error and overlay error, supplied from the calculation unit 7, to a predetermined reference value to decide whether the total pattern quality of the circuit pattern is in a standard range or not.

The first line pattern 11 is a pattern specialized for size measurement, which is designed to have a size (width) "a." The second line pattern 12 is a pattern specialized for size measurement, which is designed to have a size (width) "c," as well. The first and second line patterns 11 and 12 are arranged to have a distance "b" so that no problem occurs in the formation thereof. The distance "b" between the line patterns 11 and 12 is arbitrarily designed. For example, the above mentioned sizes "a," b" and "c" may be 0.5 $\mu$ m, 1 $\mu$ m and 0.5 $\mu$ m, respectively. As mentioned before, the size "a" of the first line pattern 11, the distance "b" between the line patterns 11 and 12 and the size "c" of the second line pattern 12 are measured by the photo detector 6, shown in Fig. 1.

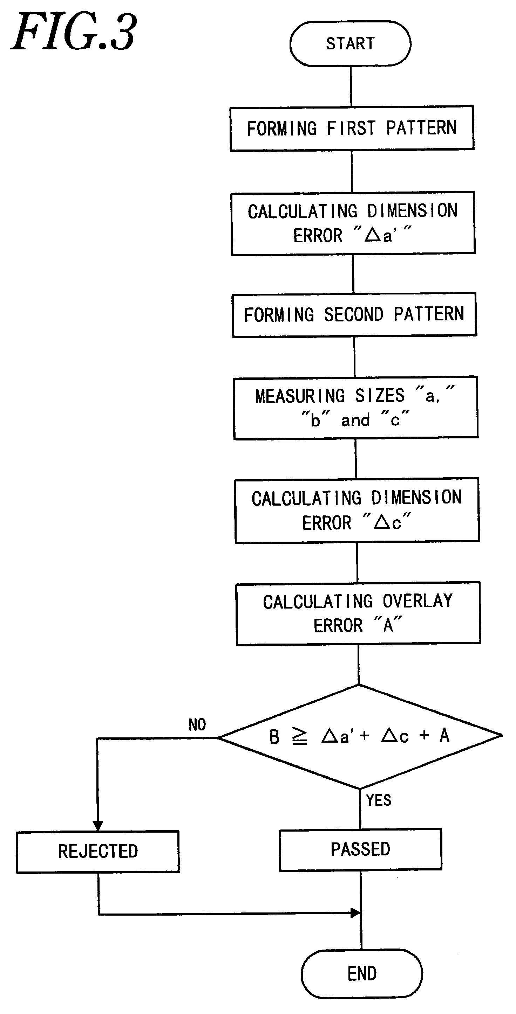

Fig. 3 shows the steps for deciding dimension accuracy and overlay accuracy of the circuit pattern. The calculation unit 7 decides the accuracy of the circuit pattern on the basis of the above measured values "a," "b" and "c" as follows:

(1) First, the calculation unit 7 decides whether the measured value "c" of the second line pattern 12 is within the allowable standard range or not. When it is in the allowable standard range, the difference $\Delta c$ from its design value (dimension error) is calculated. If the value "c" is out of the standard range, the wafer 2 is reprocessed.
(2) Next, the calculation unit 7 calculates an overlay error of the second line pattern 12 relative to the first line pattern 11. The overlay error "A" is calculated in accordance with the following equation:

$$\text{Overlay Error (A)} = \text{Measured Value } [(a/2) + b + (c/2)] - \text{Design Value } [(a/2) + b + (c/2)]$$

The size "a" of the first line pattern 11 has been measured before the second line pattern 12 is formed, and the size is always in the allowable range. It is assumed that a dimension error of the first line pattern 11 relative to its design value is $\Delta$a'.

The overlay accuracy is decided in accordance with the following formula:

$$B \geqq a' + \triangle c + A$$

where "B" is the standard range of overlay accuracy
When it meets the above formula, the circuit pattern is decided to be acceptable.

According to the above mentioned method, the first and second line patterns 11 and 12 are measured in size at the same time, so that the dimension accuracy and overlay accuracy of the circuit pattern can be decided with a single measurement device (6, 7 and 8).

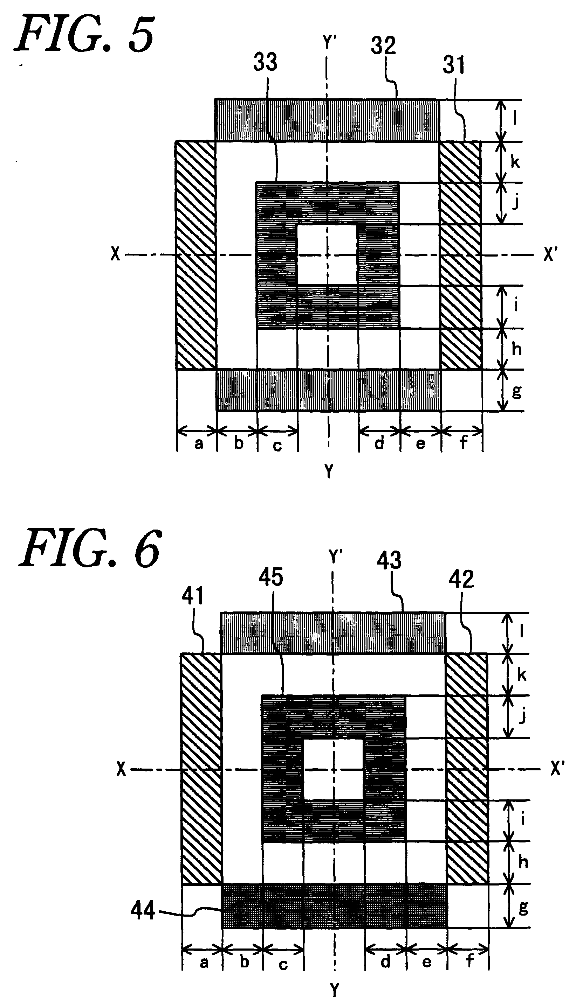

Fig. 4 shows a measurement pattern set, transferred onto the surface of the wafer 2, according to a second preferred embodiment of the invention. The measurement pattern set includes a first measurement pattern 21, formed on a lower layer (reference layer), and a second measurement pattern 12, formed on an upper layer. The lower layer is to be the basis of overlay accuracy measurement of the upper layer. Each of the first and second measurement patterns 21 and 22 is shaped to be a square frame. The second measurement pattern 22 is arranged to surround the first measurement pattern 21 at the center.

The first measurement pattern 21 is designed to have frame widths of "c," "d," "i" and "j," which are appropriate for size control, and to have lengths that are long enough to measure the sizes "c," "d," "i" and "j." The frame widths "c," "d," "i" and "j" of the first measurement pattern 21 are designed to be appropriate, not too large nor too small, so that the sizes are close to those of the circuit pattern formed on the same layer (upper layer).

The second measurement pattern 22 is formed in the same manner as the first embodiment. The second measurement pattern 22 is a resist pattern, which is designed to have frame widths of "a," "f," "g" and "l" to provide a size target. The frame widths "a," "f," "g,' and "l" of the second measurement pattern 21 are designed to be appropriate, not too large nor too small, so that the sizes are close to those of the circuit pattern formed on the same layer (upper layer).

The first and second measurement patterns 21 and 22 are arranged to have arbitrary distances "b," "e," "h" and "k" so that the second measurement pattern 22 can be formed without any effect of the first measurement pattern 21. In this embodiment, the first and second measurement patterns 21 and 22 are designed to meet the relation of

"c = d = i = j ," "a = f = g = l ,' and "b = e = h = k ." For example, the first measurement pattern 21 is designed to have an inner width D of 1 to 2 μ m.

For providing dimension accuracy and overlay accuracy of the circuit pattern, first, every size of thus formed first and second measurement patterns 21 and 22 is measured. In the measurement pattern set, it is assumed that the horizontal direction is X and the vertical direction is Y. Every size of the first and second measurement patterns 21 and 22 arranged within an area of X-X' and Y-Y' is measured in a single plane at the same time.

In accordance with the results of the measurement, a dimension error $\triangle 22x$ of the second measurement pattern 22 in the X direction relative to its design value is calculated as follows:

$$\triangle 22x = (a+f)/2.$$

Now, it is assumed that a dimension error of the first measurement pattern 21 in the X direction relative to its design value is $\Delta 21x$, which has been measured in advance. An overlay error $\Delta x$ in the X direction between the first and second measurement patterns 21 and 22 is calculated in accordance with the following equation:

$$(\Delta x) = MeasuredValue\,[(a/2)+b+(c/2)+(d/2)+e+(f/2)]/2 - Design\,Value\,[(a/2)+b+(c/2)+(d/2)+e+(f/2)]/2$$

When the above calculated values $\Delta 21x$, $\Delta 22x$ and $\Delta x$ meet the following relation (formula), the circuit pattern is decided to be acceptable, there "x" is a predetermined range of total accuracy standard:

$$x \geqq \Delta 21x + \Delta x + \Delta 22x$$

In the same manner as the X direction, measurement of the second measurement pattern 22 in the Y direction is performed. With the pattern arrangement of the second embodiment, measurement can be performed both in the X and Y directions at the same time, and therefore, pattern accuracy data of the circuit pattern can be provided in each direction independently.

In this embodiment, although size data are taken from both right and left sides of the pattern, size data only at one of those sides can be used for deciding the pattern accuracy with the same advantage. The measurement of the patterns 21 and 22, calculation process of dimension error and overlay error, and decision process of pattern quality of the circuit pattern are performed by the apparatus, shown in Fig. 1, in the same manner as the first preferred embodiment.

As described above, according to the second preferred embodiment, every size of the first and second measurement patterns 21 and 22 can be measured both in X and Y directions at the same time, and therefore, the pattern quality of the circuit pattern can be decided for each direction easily.

Fig. 5 shows a measurement pattern set, transferred onto the surface of the wafer 2, according to a third preferred embodiment of the invention. In this embodiment, overlay accuracy of a circuit pattern is decided using different reference layers for X and Y directions, respectively. The measurement pattern set includes a first pair of measurement patterns 31, a second pair of measurement patterns 32 and a third measurement pattern 33. The first pair of measurement patterns 31 are designed to extend in a Y direction, and the second pair of measurement patterns 32 are designed to extend in an X direction. The third measurement pattern 33 is shaped to be a square frame.

The first and second pairs of measurement patterns 31 and 32 are formed on a first layer, which is the lowest, and on a second layer, which is on the first layer, respectively. The third layer 33 is formed on the top layer, on which the circuit pattern is transferred as well. The first pair of measurement patterns 31 are formed in the same manner as the patterns described in the first and second preferred embodiments.

In the same manner as the second preferred embodiment, a dimension error $\Delta 31x$ of the measurement patterns 31 relative to its design value, a dimension error $\Delta 33x$ of the measurement patterns 33 relative to its design value and an overlay error $\Delta x$ between the measurement patterns 31 and 33 are calculated. In accordance with the following formula, pattern accuracy of the circuit pattern is decided in the X direction:

$$x \geqq \Delta 31x + \Delta x + \Delta 33x$$

where "x" is a predetermined range of total accuracy standard of the circuit pattern.

In the Y direction, measurement of the patterns 31 to 33 and calculation of dimension accuracy and overlay accuracy are performed in the same manner as those in the X direction. The first and second pairs of measurement patterns 31 and 32 are formed in the different layers, so that the overlay accuracy of the circuit pattern on the top layer can be decided relative to two different layers independently.

The measurement of the patterns 31 to 33, calculation process of dimension error and overlay error, and decision process of pattern quality of the circuit pattern are performed by the apparatus, shown in Fig. 1, in the same manner as the first preferred embodiment.

According to the third preferred embodiment, every size of the measurement patterns 31 to 33 can be measured both in X and Y directions at the same time, and the pattern accuracy of the circuit pattern can be decided relative to the different layers for each direction easily.

Fig. 6 shows a measurement pattern set, transferred onto the surface of the wafer 2, according to a fourth preferred embodiment of the invention. In this embodiment, overlay accuracy of a circuit pattern is decided relative to two different layers in each direction of X and Y. The measurement pattern set includes first to fifth measurement patterns 41 to 45. The first and second measurement patterns 41 and 42 are designed to extend in the Y direction, at the right and left sides of a line Y-Y', respectively. The third and fourth measurement patterns 43 and 44 are designed to extend in the X direction, at the upper and lower sides of a line X-X', respectively. The fifth measurement pattern 45 is shaped to be a square frame, surrounded by the first to fourth measurement patterns 41 to 44.

The first to fifth measurement patterns 41 to 45 are formed on different layers in order lowest to top. The circuit pattern is formed on the top layer with the fifth measurement pattern 45. The first and second measurement layers 41 and 42 are used for measuring overlay accuracy of the circuit pattern in the X direction. The third and fourth measurement layers 43 and 44 are used for measuring overlay accuracy of the circuit pattern in the Y direction.

For measuring the measurement patterns 41 to 45, first, every size in the X direction (X-X') is measured. A dimension error $\Delta a$ of the first measurement pattern 41 relative to its design value and a dimension error $\Delta f$ of the second measurement pattern 42 relative to its design value are obtained in advance when those patterns are formed. In accordance with the result of the measurement in the X direction, the average of sizes "c" and "d" of the fifth measurement pattern 45 is calculated, and then a dimension error $\Delta 45$ of the fifth measurement pattern 45 is calculated relative to its design value.

An overlay error $\Delta(41\text{-}45)$ between the first and fifth measurement patterns 41 and 45 is calculated in accordance with an equation of "$\Delta(41\text{-}45) = (a/2) + b + (c/2)$." Accordingly, the total accuracy (pattern quality) of the pattern 45 relative to the pattern 41 is decided in accordance with the following formula:

$$x1 \geqq \Delta a + \Delta(41\text{-}45) + \Delta 45$$

where "x1" is an allowable range of accuracy standard. The total accuracy of the pattern 45 relative to the pattern 41 means the pattern quality of the circuit pattern formed on the top layer relative to the lowest layer, on which the first measurement pattern 41 is formed.

In the same manner, an overlay error $\Delta(42\text{-}45)$ between the second and fifth measurement patterns 42 and 45 is calculated in accordance with an equation of "$\Delta(42\text{-}45) = (d/2) + e + (f/2)$." The total accuracy of the fifth measurement pattern 45 relative to the second measurement pattern 42 is decided in accordance with the following formula:

$$x2 \geqq f + \Delta(42\text{-}45) + \Delta 45$$

where "$\Delta e$" is an allowable range of accuracy standard. The total accuracy of the pattern 45 relative to the pattern 42 means the pattern quality of the circuit pattern formed on the top layer relative to the lower layer, on which the second measurement pattern 42 is formed.

In the Y direction, a dimension error of each of the measurement patterns 43, 44 and 45 is measured, and overlay accuracy of the fifth measurement pattern 45 relative to the third and fourth measurement patterns 43 and 44 is measured, respectively. In accordance with the result of the measurement, a pattern quality of the circuit pattern can be decided.

The measurement of the patterns 41 to 45, calculation process of dimension error and overlay error, and decision process of pattern quality of the circuit pattern are performed by the apparatus, shown in Fig. 1, in the same manner as the first preferred embodiment.

According to the fourth preferred embodiment, the pattern quality of the circuit pattern can be decided relative to two different processes (layers) in the X direction, and it can be decided relative to another two different processes (layers) in the Y direction, as well. Namely, the measurement patterns can be measured both in X and Y directions at the same time, and the pattern quality of the circuit pattern can be decided relative to four different processes (layers). If other patterns are formed outside the measurement patterns 41 and 42, the number of processes relative to which the pattern quality is decided can be increased.

Although the invention has been described with respect to the specific embodiments for complete and clear disclosure, the appended claims are not be thus limited but are to be construed as embodying all modification and alternative constructions that may occur to one skilled in the art which fairly fall within the basic teaching herein set forth.

## Claims

1. A measurement pattern set used for measuring dimension accuracy and overlay accuracy of a circuit pattern transferred onto a substrate surface, comprising:

a first pattern formed on a lower layer, which is to be the basis of the measurement; and
a second pattern formed on an upper layer that is the same level of the circuit pattern, in which the second pattern is arranged to adjoin to the first pattern, wherein
the first and second patterns are measured in size so as to calculate a dimension error of the second pattern relative to its design value and an overlay error of the second pattern relative to the first pattern at the same time, and then the dimension accuracy and overlay accuracy of the circuit pattern is calculated in response to the above calculated dimension error and the overlay error.

2. The measurement pattern set, according to claim 1, wherein

the dimension error and the overlay error are summed up, and the sum is compared to a predetermined reference value to decide whether the total pattern quality of the circuit pattern is in a standard range or not.

3. The measurement pattern set, according to claim 1, wherein

each of the first and second patterns is designed so that sizes both in X and Y directions are measured at the same time.

4. The measurement pattern set, according to claim 3, wherein

the first pattern includes a pair of line patterns which extend in the X and Y directions on the difference layers, respectively.

5. The measurement pattern set, according to claim 4, wherein

the first pattern includes a pair of line patterns which are arranged at both sides of a line extending in the X direction on two different layers, respectively; and another pair of line patterns which are arranged at both sides of a line extending in the Y direction on another two different layers, respectively, so that the overlay accuracy is measured relative to each of those four different layers.

6. A method for measuring dimension accuracy and overlay accuracy of a circuit pattern transferred onto a substrate surface, comprising the steps of:

forming a first pattern on a lower layer, which is to be the basis of the measurement;
forming a second pattern on an upper layer that is the same level of the circuit pattern, in which the second pattern is arranged to adjoin to the first pattern;
measuring sizes of the first and second patterns so as to calculate a dimension error of the second pattern relative to its design value and an overlay error of the second pattern relative to the first pattern at the same time; and
calculating the dimension accuracy and overlay accuracy of the circuit pattern in response to the above calculated dimension error and the overlay error.

7. The method, according to claim 6, wherein

the dimension error and the overlay error are summed up, and the sum is compared to a predetermined reference value to decide whether the total pattern quality of the circuit pattern is in a standard range or not.

8. The method, according to claim 6, wherein

in the step of forming the first and second patterns, each of the first and second patterns is designed so that sizes both in X and Y directions are measured at the same time, and
in the step of measuring the first and second patterns, the first and second patterns are measured in the X and Y directions at the same time to provide the dimension accuracy and overlay accuracy in each direction.

9. The method, according to claim 8, wherein

in the step of forming the first pattern, a pair of line patterns are formed to extend in the X and Y directions on the difference layers, respectively, so that the overlay accuracy is measured relative to those two different layers.

**10.** The method, according to claim 9, wherein

in the step of forming the first pattern, a pair of line patterns are arranged at both sides of a line extending in the X direction on two different layers, respectively; and another pair of line patterns which are arranged at both sides of a line extending in the Y direction on another two different layers, respectively, so that the overlay accuracy is measured relative to each of those four different layers.

**11.** An apparatus for measuring dimension accuracy and overlay accuracy of a circuit pattern transferred onto a substrate surface, comprising:

a measurement device that measures sizes of first and second patterns at the same time, in which the first pattern is formed on a lower layer and the second pattern is formed on an upper layer that is the same level of the circuit pattern;
a calculation unit that calculates a dimension error of the second pattern relative to its design value and an overlay error of the second pattern relative to the first pattern at the same time, and sums up the dimension error and the overlay error; and
a decision unit that compares the sum of the dimension error and overlay error of the second pattern to a predetermined reference value to decide whether the total pattern quality of the circuit pattern is in a standard range or not.

**12.** The apparatus, according to claim 11, wherein

each of the first and second patterns is designed so that sizes both in X and Y directions are measured at the same time, and
the measurement device measures the first and second patterns in the X and Y directions at the same time to provide the dimension accuracy and overlay accuracy in each direction.

**13.** The apparatus, according to claim 12, wherein

the first pattern includes a pair of line patterns which extend in the X and Y directions on the difference layers, respectively, so that the overlay accuracy is measured relative to those two different layers.

**14.** The apparatus, according to claim 13, wherein

the first pattern includes a pair of line patterns which are arranged at both sides of a line extending in the X direction on two different layers, respectively; and another pair of line patterns which are arranged at both sides of a line extending in the Y direction on another two different layers, respectively, so that the overlay accuracy is measured relative to each of those four different layers.

**15.** A method of measuring dimensional accuracy and overlay accuracy of a circuit pattern on a semiconductor substrate, comprising:

forming a first measurement pattern on a reference layer of the substrate;
forming a second measurement pattern on a layer of the substrate overlying the reference layer; and
measuring the dimensions of, and the separation between, the first and second measurement patterns, so as to enable concurrent determination of the dimensional and overlay accuracy of a circuit pattern formed on the overlying layer of the substrate.

# FIG. 1

```
┌──────────────┐
│   DECISION   │──── 8
│     UNIT     │
└──────────────┘
        ▲
        │
┌──────────────┐
│ CALCULATION  │──── 7
│     UNIT     │
└──────────────┘
        ▲
        │        6
┌──────────────┐
│    PHOTO     │
│   DETECTOR   │
└──────────────┘
```

4 WAFER STAGE

2 WAFER

# FIG. 2

# FIG. 4

# FIG.3

```
            ( START )
                |
                v
    +-----------------------+
    |  FORMING FIRST PATTERN |
    +-----------------------+
                |
                v
    +-----------------------+
    | CALCULATING DIMENSION |
    |     ERROR "△a'"       |
    +-----------------------+
                |
                v
    +-----------------------+
    | FORMING SECOND PATTERN |
    +-----------------------+
                |
                v
    +-----------------------+
    |  MEASURING SIZES "a," |
    |     "b" and "c"       |
    +-----------------------+
                |
                v
    +-----------------------+
    | CALCULATING DIMENSION |
    |     ERROR "△c"        |
    +-----------------------+
                |
                v
    +-----------------------+
    |  CALCULATING OVERLAY  |
    |      ERROR "A"        |
    +-----------------------+
                |
                v
    NO    <  B ≧ △a' + △c + A  >
    |                |
    |               YES
    v                v
+-----------+   +-----------+
| REJECTED  |   |  PASSED   |
+-----------+   +-----------+
    |                |
    +----------------+
                |
                v
            ( END )
```

# FIG. 5

# FIG. 6

European Patent
Office

**EUROPEAN SEARCH REPORT**

Application Number

EP 97 31 0515

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 5 498 877 A (SHIRAKI SEIICHI) 12 March 1996<br><br>Entire document | 1,3,4,6, 8,9, 11-13,15 | H01L21/66<br>G03F7/20 |
| A | | 2,5,7, 10,14 | |
| A | US 5 646 452 A (NARIMATSU KOICHIRO) 8 July 1997<br>* column 3-5 * | 1-15 | |
| A | US 5 543 921 A (UZAWA SHIGEYUKI ET AL) 6 August 1996<br>* column 1-2 * | 1-15 | |
| | | | **TECHNICAL FIELDS SEARCHED** (Int.Cl.6)<br><br>H01L<br>G03F |

The present search report has been drawn up for all claims

| Place of search | Date of completion of the search | Examiner |
|---|---|---|
| THE HAGUE | 1 September 1998 | Odgers, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)